# EUROPEAN PATENT SPECIFICATION

(11) **EP 1 138 906 B1**
(45) Date of publication and mention of the grant of the patent: **08.10.2003**
(21) Application number: 00106966.5
(22) Date of filing: 01.04.2000
(51) Int. Cl.: F02D 41/20, H01L 41/04

(54) **Optimization of injection systems having piezoelectric elements by compensating for temperature dependence**
Optimierung von Einspritzsystemen, die piezoelektrische Elemente verwenden , durch Kompensation der Temperaturabhängigkeit
Optimisation de systèmes d'injection à éléments piézoélectriques par compensation de leur dépendance de la température

(43) Date of publication of application: 04.10.2001
(73) Proprietor: Robert Bosch GmbH, 70469 Stuttgart (DE)
(72) Inventor: Rueger, Johannes-Joerg, 71665 Vaihingen/Enz (DE); Schulz, Udo, 71665 Vaihingen/Enz (DE)

(56) References cited:
- DE-A- 19 805 184
- PATENT ABSTRACTS OF JAPAN vol. 013, no. 477 (M-885), 27 October 1989 (1989-10-27) & JP 01 187345 A (TOYOTA MOTOR CORP), 26 July 1989 (1989-07-26)
- PATENT ABSTRACTS OF JAPAN vol. 018, no. 188 (E-1532), 31 March 1994 (1994-03-31) & JP 05 344755 A (TOYOTA MOTOR CORP), 24 December 1993 (1993-12-24)

## Description

The present invention relates to a method and an apparatus for setting an activation voltage for charging a piezoelectric element while considering the temperature dependence hysteresis of the piezoelectric element. The fuel injection system and the method for operating a fuel injection system according to the preamble of claims 1 and 5 is known from DE 198 05 184 A.

The present piezoelectric elements being considered here in more detail are, in particular but not exclusively, piezoelectric elements used as actuators. Piezoelectric elements can be used for such purposes because, as is known, they possess the property of contracting or expanding as a function of a voltage applied thereto or occurring therein.

The practical implementation of actuators using piezoelectric elements proves to be advantageous in particular if the actuator in question must perform rapid and/or frequent movements.

Piezoelectric elements are capacitive elements which, as already partially alluded to above, contract and expand in accordance with the particular charge state or the voltage occurring therein or applied thereto. In the example of a fuel injection nozzle, expansion and contraction of piezoelectric elements is used to control valves that manipulate the linear strokes of injection needles. German patent applications DE 197 42 073 A1 and DE 197 29 844 A1, which are incorporated herein by reference, disclose piezoelectric elements with double acting, double seat valves for controlling injection needles in a fuel injection system.

Fuel injection systems using piezoelectric elements as actuators are characterized by the fact that, to a first approximation, piezoelectric elements exhibit a proportional relationship between applied voltage and the linear expansion. In a fuel injection nozzle, for example, implemented as a double acting, double seat valve to control the linear stroke of a needle for fuel injection into a cylinder of an internal combustion engine, the amount of fuel injected into a corresponding cylinder is a function of the time the valve is open and how far the valve is open. In the case of the use of a piezoelectric element, the amount of injected fuel is a function of the activation voltage applied to the piezoelectric element and the timing of the applied voltage.

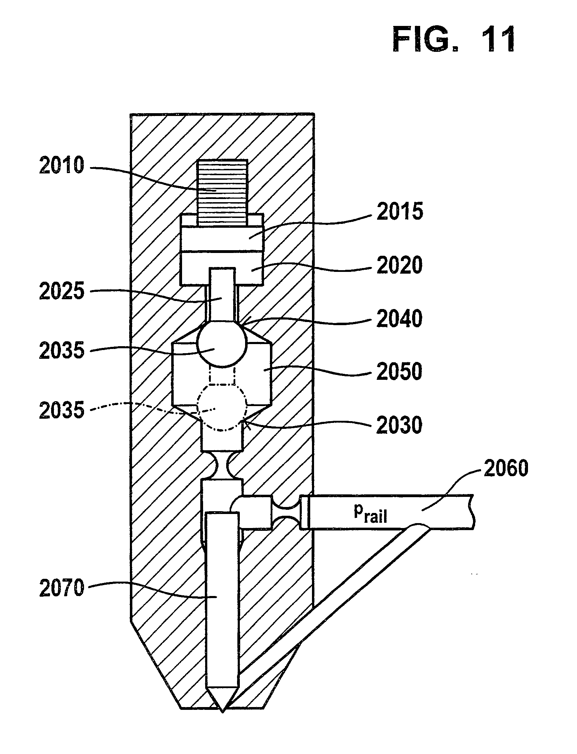

Fig. 11 is a schematic representation of a fuel injection system using a piezoelectric element 2010 as an actuator. Referring to Fig. 11, the piezoelectric element 2010 is electrically energized to expand and contract in response to a given activation voltage. The piezoelectric element 2010 is coupled to a piston 2015. In the expanded state, the piezoelectric element 2010 causes the piston 2015 to protrude into a hydraulic adapter 2020 which contains a hydraulic fluid, for example fuel. As a result of the piezoelectric element's expansion, a double acting control valve 2025 is hydraulically pushed away from hydraulic adapter 2020 and the valve plug 2035 is extended away from a first closed position 2040. The combination of double acting control valve 2025 and hollow bore 2050 is often referred to as double acting, double seat valve for the reason that when piezoelectric element 2010 is in an unexcited state, the double acting control valve 2025 rests in its first closed position 2040. On the other hand, when the piezoelectric element 2010 is fully extended, it rests in its second closed position 2030. The later position of valve plug 2035 is schematically represented with ghost lines in Fig. 11.

It is important to determine and apply an activation voltage with sufficient precision such that, for example, a corresponding valve plug is accurately positioned at the appropriate time in the fuel injection cycle. Thus it is important to be able to detect various problems in the electrical circuit driving the piezoelectric elements. One such problem is a short circuit to the battery voltage within, or at the terminals of, one or more of the piezoelectric elements.

The fuel injection system comprises an injection needle 2070 allowing for injection of fuel from a pressurized fuel supply line 2060 into the cylinder (not shown). When the piezoelectric element 2010 is unexcited or when it is fully extended, the double acting control valve 2025 rests respectively in its first closed position 2040 and in its second closed position 2030. In either case, the hydraulic rail pressure maintains injection needle 2070 at a closed position. Thus, the fuel mixture does not enter into the cylinder (not shown). Conversely, when the piezoelectric element 2010 is excited such that double acting control valve 2025 is in the so-called mid-position with respect to hollow bore 2050, then there is a pressure drop in the pressurized fuel supply line 2060 so that the injection needle 2070 is fully lifted allowing for fuel injection into the cylinder (not shown).

It has proven to be difficult to determine and apply an activation voltage with sufficient precision such that, for example, a corresponding valve plug is accurately positioned for maximum fuel flow.

Therefore an object of the present invention is an apparatus and method for charging a piezoelectric element used in a fuel injection system in such a way that an activation voltage level for a piezoelectric element is set with sufficient precision to, for example, accurately position a valve plug for maximum fuel flow. The particular piezoelectric element can be one of several piezoelectric elements used as actuators in a system such as, for example, a fuel injection system.

This object is achieved, according to the present invention, by way of the features claimed in the characterizing portion of claim 1 (apparatus) and in the characterizing portion of claim 5 (method).

More specifically, it has been found that a temperature-dependent hysteresis effect has to be taken into account to accurately position the valve plug. For example, at different temperatures, the piezoelectric element possesses different travel or lift characteristics at different voltages depending upon whether the activation voltage is approached from a lower voltage or a higher voltage. If this effect is not taken into account, the control valve's position and the fuel injection operation would perform with reduced accuracy.

In order to determine the effect of the piezoelectric element temperature, characteristic curves are used. These characteristic curves use the piezoelectric temperature as an input parameter in addition to a number of other parameters. However, since the piezoelectric element's temperature is difficult to measure directly, the piezoelectric's capacitance can be advantageously used instead. The piezoelectric element's capacitance can be measured on a cylinder-by-cylinder basis during every drive signal. That is, the drive voltage and charge quantities flowing, or the average current, can be multiplied by the charging/discharging time to obtain the piezoelectric element's capacitance. Since the piezoelectric element capacitance also exhibits temperature response, the capacitance can be used to derive the piezoelectric element temperature and in turn, the desired maximum travel of the piezoelectric element.

As such, this invention provides for compensating for the temperature hysteresis effects of the piezoelectric elements. 25 A resulting advantage is by considering these effects, the maximum actuator travel can be estimated with a considerably greater accuracy such that the activation voltage could be adjusted accordingly.

Other advantages of the present invention are evident from the dependent claims, the description below, and the exemplary embodiments represented in drawings. where:
- Fig. 1: shows a graph depicting the relationship between activation voltage and injected fuel volume in a fixed time period for the example of a double acting control valve;
- Fig. 2: shows a schematic profile of an exemplary control valve stroke and a corresponding nozzle needle lift for the example of a double acting control valve;
- Fig. 3: shows a block diagram of an exemplary embodiment of an arrangement in which the present invention may be implemented;
- Fig. 4a: shows a depiction to explain the conditions occurring during a first charging phase (charging switch 220 closed) in the circuit of Fig. 3;
- Fig. 4b: shows a depiction to explain the conditions occurring during a second charging phase (charging-switch 220 open again) in the circuit of Fig. 3;
- Fig. 4c: shows a depiction to explain the conditions occurring during a first discharging phase (discharging switch 230 closed) in the circuit of Fig. 3;
- Fig. 4d: shows a depiction to explain the conditions occurring during a second discharging phase (discharging switch 230 open again) in the circuit of Fig. 3;
- Fig. 5: shows a block diagram of components of the activation IC E which is also shown in Fig. 3;
- Fig. 6: shows a block diagram of software modules implemented in the control unit D and the activation IC E which are also shown in Fig. 3, as well as the coupling between these modules, a fuel injection system and a corresponding internal combustion engine;
- Fig. 7: shows a schematic block diagram of a method to determine the undesired voltage offset due to temperature hysteresis effects;
- Fig. 8: shows a graph illustrating two exemplary actuator hysteresis curves as a function of temperature and voltage;
- Fig. 9: shows a graph illustrating the expansion of a piezoelectric element versus time as a function of driving voltage; and
- Fig. 10: shows a schematic of the method to determine an offset voltage at three particular points of the fuel injection process.
- Fig. 11: shows a schematic of a fuel injection valve actuated by a piezoelectric element.

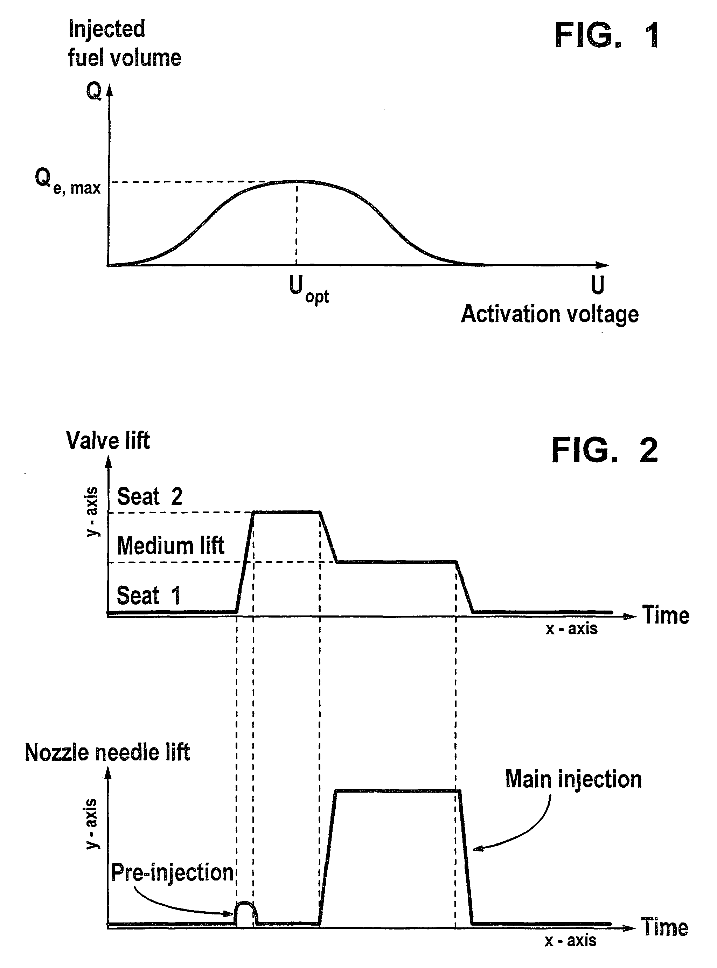

Fig. 1 shows a graph depicting the relationship between activation voltage and injected fuel volume during a preselected fixed time period, for an exemplary fuel injection system using piezoelectric elements acting upon double acting control valves. The y-axis represents volume of fuel injected into a cylinder chamber during the preselected fixed period of time. The x-axis represents the activation voltage applied to or stored in the corresponding piezoelectric element, used to displace a valve plug of the double acting control valve.

At x=0, y=0, the activation voltage is zero, and the valve plug is seated in a first closed position to prevent the flow of fuel during the preselected fixed period of time. For values of the activation voltage greater than zero, up to the x-axis point indicated as Uₒₚₜ, the represented values of the activation voltage cause the displacement of the valve plug away from the first closed position and towards the second closed position, in a manner that results in a greater volume of injected fuel for the fixed time period, as the activation voltage approaches Uₒₚₜ, up to the value for volume indicted on the y-axis by Q_{e,max}. The point Q_{e,max}, corresponding to the greatest volume for the injected fuel during the fixed period of time, represents the value of the activation voltage for application to or charging of the piezoelectric element, that results in an optimal displacement of the valve plug between the first and second valve seats, i.e the first and second closed positions.

As shown on the graph of Fig. 1, for values of the activation voltage greater than Uₒₚₜ, the volume of fuel injected during the fixed period of time decrease until it reaches zero. This represents displacement of the valve plug from the optimal point and toward the second closed position of the double acting control valve until the valve plug reaches the second closed position. Thus, the graph of Fig. 1 illustrates that a maximum volume of fuel injection occurs when the activation voltage causes the piezoelectric element to displace the valve plug to the optimal point.

The present invention teaches that the value for Uₒₚₜ at any given time for a particular piezoelectric element is influenced by the operating characteristics of the particular piezoelectric element at that time. That is, the amount of displacement caused by the piezoelectric element for a certain activation voltage varies as a function of the operating characteristics of the particular piezoelectric element. Accordingly, in order to achieve a maximum volume of fuel injection, Q_{e,max}, during a given fixed period of time, the activation voltage applied to or occurring in the piezoelectric element should be set to a value relevant to current operating characteristics of the particular piezoelectric element, to achieve Uₒₚₜ.

Fig. 2 shows a double graph representing a schematic profile of an exemplary control valve stroke, to illustrate the double acting control valve operation discussed above. In the upper graph of Fig. 2, the x-axis represents time, and the y-axis represents displacement of the valve plug (valve lift). In the lower graph of Fig. 2, the x-axis once again represents time, while the y-axis represents a nozzle needle lift to provide fuel flow, resulting from the valve lift of the upper graph. The upper and lower graphs are aligned with one another to coincide in time, as represented by the respective x-axises.

During an injection cycle, the piezoelectric element is charged resulting in an expansion of the piezoelectric element, as will be described in greater detail, and causing the corresponding valve plug to move from the first closed position to the second closed position for a pre-injection stroke, as shown in the upper graph of Fig. 2. The lower graph of Fig. 2 shows a small injection of fuel that occurs as the valve plug moves between the two seats of the double acting control valve, opening and closing the valve as the plug moves between the first and second closed positions. In general, the charging of the piezoelectric element can be done in two steps: the first one is to charge it to a certain voltage and cause the valve to open, and the second one is to charge it further and cause the valve to close again at the second closed position. Between steps, in general, there can be a certain time delay.

After a preselected period of time, a discharging operation is then performed, as will be explained in greater detail below, to reduce the charge within the piezoelectric element so that it contracts, as will also be described in greater detail, causing the valve plug to move away from the second closed position, and hold at a midway point between the two seats. As indicated in Fig. 1, the activation voltage within the piezoelectric element is to reach a value that equals Uₒₚₜ to correspond to an optimal point of the valve lift, and thereby obtain a maximum fuel flow, Q_{e, max}, during the period of time allocated to a main injection. The upper and lower graphs of Fig. 2 show the holding of the valve lift at a midway point, resulting in a main fuel injection.

At the end of the period of time for the main injection, the piezoelectric element is discharged to an activation voltage of zero, resulting in further contraction of the piezoelectric element, to cause the valve plug to move away from the optimal position, towards the first closed position, closing the valve and stopping fuel flow, as shown in the upper and lower graphs of Fig. 2. At this time, the valve plug will once again be in a position to repeat another pre-injection, main injection cycle, as just described above, for example. Of course, any other injection cycle can be performed.

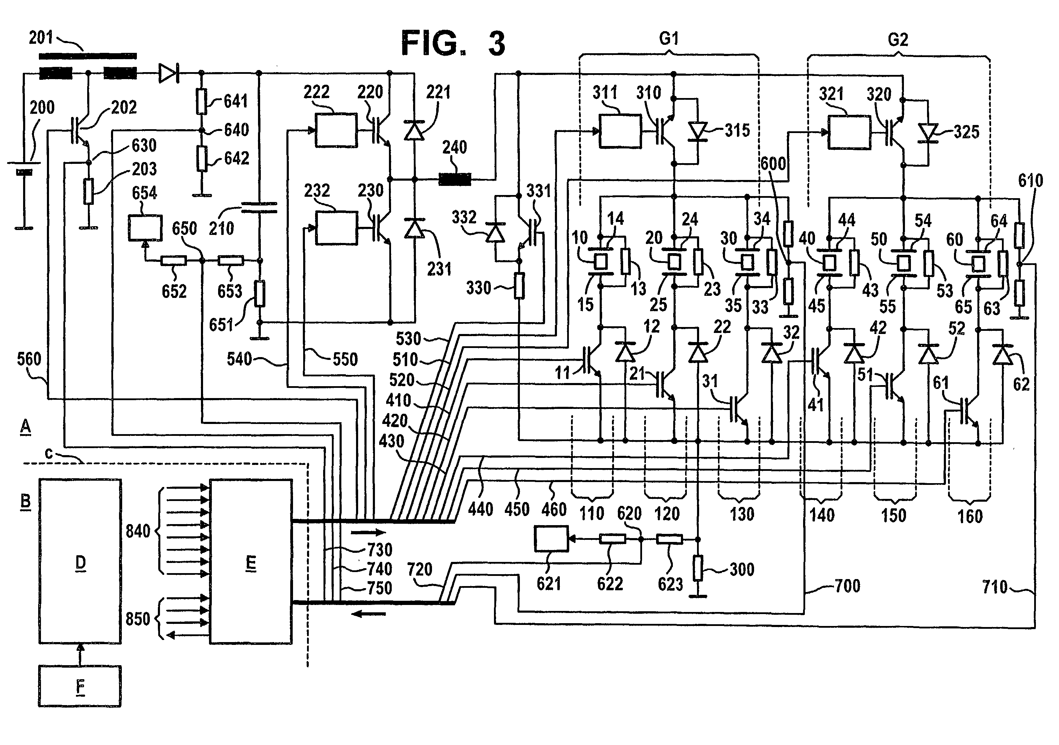

Fig. 3 provides a block diagram of an exemplary embodiment of an arrangement in which the present invention may be implemented.

In Fig. 3 there is a detailed area A and a non-detailed area B, the separation of which is indicated by a dashed line c. The detailed area A comprises a circuit for charging and discharging piezoelectric elements 10, 20, 30, 40, 50 and 60. In the example being considered these piezoelectric elements 10, 20, 30, 40, 50 and 60 are actuators in fuel injection nozzles (in particular in so-called common rail injectors) of an internal combustion engine. Piezoelectric elements can be used for such purposes because, as is known, and as discussed above, they possess the property of contracting or expanding as a function of a voltage applied thereto or occurring therein. The reason to take six piezoelectric elements 10, 20, 30, 40, 50 and 60 in the embodiment described is to independently control six cylinders within a combustion engine; hence, any other number of piezoelectric elements might match any other purpose.

The non-detailed area B comprises a control unit D and a activation IC E by both of which the elements within the detailed area A are controlled, as well as a measuring system F for measuring system operating characteristics such as, for example, fuel pressure and rotational speed (rpm) of the internal combustion engine for input to and use by the control unit D, according to the present invention, as will be described in detail below. According to the present invention, the control unit D and activation IC E are programmed to control activation voltages for piezoelectric elements as a function of operating characteristics of the each particular piezoelectric element.

The following description firstly introduces the individual elements within the detailed area A. Then, the procedures of charging and discharging piezoelectric elements 10, 20, 30, 40, 50, 60 are described in general. Finally, the ways both procedures are controlled by means of control unit D and activation IC E, according to the present invention, are described in detail.

The circuit within the detailed area A comprises six piezoelectric elements 10, 20, 30, 40, 50 and 60.

The piezoelectric elements 10, 20, 30, 40, 50 and 60 are distributed into a first group G1 and a second group G2, each comprising three piezoelectric elements (*i*.*e*., piezoelectric elements 10, 20 and 30 in the first group G1 resp. 40, 50 and 60 in the second group G2). Groups G1 and G2 are constituents of circuit parts connected in parallel with one another. Group selector switches 310, 320 can be used to establish which of the groups G1, G2 of piezoelectric elements 10, 20 and 30 resp. 40, 50 and 60 will be discharged in each case by a common charging and discharging apparatus (however, the group selector switches 310, 320 are meaningless for charging procedures, as is explained in further detail below).

The group selector switches 310, 320 are arranged between a coil 240 and the respective groups G1 and G2 (the coil-side terminals thereof) and are implemented as transistors. Side drivers 311, 321 are implemented which transform control signals received from the activation IC E into voltages which are eligible for closing and opening the switches as required.

Diodes 315 and 325 (referred to as group selector diodes), respectively, are provided in parallel with the group selector switches 310, 320. If the group selector switches 310, 320 are implemented as MOSFETs or IGTBs, for example, these group selector diodes 315 and 325 can be constituted by the parasitic diodes themselves. The diodes 315, 325 bypass the group selector switches 310, 320 during charging procedures. Hence, the functionality of the group selector switches 310, 320 is reduced to select a group G1, G2 of piezoelectric elements 10, 20 and 30, resp. 40, 50 and 60 for a discharging procedure only.

Within each group G1 resp. G2 the piezoelectric elements 10, 20 and 30, resp. 40, 50 and 60 are arranged as constituents of piezo branches 110, 120 and 130 (group G1) and 140, 150 and 160 (group G2) that are connected in parallel. Each piezo branch comprises a series circuit made up of a first parallel circuit comprising a piezoelectric element 10, 20, 30, 40, 50 resp. 60 and a resistor 13, 23, 33, 43, 53 resp. 63 (referred to as branch resistors) and a second parallel circuit made up of a selector switch implemented as a transistor 11, 21, 31, 41, 51 resp. 61 (referred to as branch selector switches) and a diode 12, 22, 32, 42, 52 resp. 62 (referred to as branch diodes).

The branch resistors 13, 23, 33, 43, 53 resp. 63 cause each corresponding piezoelectric element 10, 20, 30, 40, 50 resp. 60 during and after a charging procedure to continuously discharge themselves, since they connect both terminals of each capacitive piezoelectric element 10, 20, 30, 40, 50, resp. 60 one to another. However, the branch resistors 13, 23, 33, 43, 53 resp. 63 are sufficiently large to make this procedure slow compared to the controlled charging and discharging procedures as described below. Hence, it is still a reasonable assumption to consider the charge of any piezoelectric element 10, 20, 30, 40, 50 or 60 as unchanging within a relevant time after a charging procedure (the reason to nevertheless implement the branch resistors 13, 23, 33, 43, 53 and 63 is to avoid remaining charges on the piezoelectric elements 10, 20, 30, 40, 50 and 60 in case of a breakdown of the system or other exceptional situations). Hence, the branch resistors 13, 23, 33, 43, 53 and 63 may be neglected in the following description.

The branch selector switch/branch diode pairs in the individual piezo branches 110, 120, 130, 140, 150 resp. 160, *i*.*e*., selector switch 11 and diode 12 in piezo branch 110, selector switch 21 and diode 22 in piezo branch 120, and so on, can be implemented using electronic switches (i.e., transistors) with parasitic diodes, for example MOSFETs or IGBTs (as stated above for the group selector switch/diode pairs 310 and 315 resp. 320 and 325).

The branch selector switches 11, 21, 31, 41, 51 resp. 61 can be used to establish which of the piezoelectric elements 10, 20, 30, 40, 50 or 60 will be charged in each case by a common charging and discharging apparatus: in each case, the piezoelectric elements 10, 20, 30, 40, 50 or 60 that are charged are all those whose branch selector switches 11, 21, 31, 41, 51 or 61 are closed during the charging procedure which is described below.

Usually, at any time only one of the branch selector switches is closed.

The branch diodes 12, 22, 32, 42, 52 and 62 serve for bypassing the branch selector switches 11, 21, 31, 41, 51 resp. 61 during discharging procedures. Hence, in the example considered for charging procedures any individual piezoelectric element can be selected, whereas for discharging procedures either the first group G1 or the second group G2 of piezoelectric elements 10, 20 and 30 resp. 40, 50 and 60 or both have to be selected.

Returning to the piezoelectric elements 10, 20, 30, 40, 50 and 60 themselves, the branch selector piezo terminals 15, 25, 35, 45, 55 resp. 65 may be connected to ground either through the branch selector switches 11, 21, 31, 41, 51 resp. 61 or through the corresponding diodes 12, 22, 32, 42, 52 resp. 62 and in both cases additionally through resistor 300.

The purpose of resistor 300 is to measure the currents that flow during charging and discharging of the piezoelectric elements 10, 20, 30, 40, 50 and 60 between the branch selector piezo terminals 15, 25, 35, 45, 55 resp. 65 and the ground. A knowledge of these currents allows a controlled charging and discharging of the piezoelectric elements 10, 20, 30, 40, 50 and 60. In particular, by closing and opening charging switch 220 and discharging switch 230 in a manner dependent on the magnitude of the currents, it is possible to set the charging current and discharging current to predefined average values and/or to keep them from exceeding or falling below predefined maximum and/or minimum values as is explained in further detail below.

In the example considered, the measurement itself further requires a voltage source 621 which supplies a voltage of 5 V DC, for example, and a voltage divider implemented as two resistors 622 and 623. This is in order to prevent the activation IC E (by which the measurements are performed) from negative voltages which might otherwise occur on measuring point 620 and which cannot be handled be means of activation IC E: such negative voltages are changed into positive voltages by means of addition with a positive voltage setup which is supplied by said voltage source 621 and voltage divider resistors 622 and 623.

The other terminal of each piezoelectric element 10, 20, 30, 40, 50 and 60, *i*.*e*., the group selector piezo terminal 14, 24, 34, 44, 54 resp. 64, may be connected to the plus pole of a voltage source via the group selector switch 310 resp. 320 or via the group selector diode 315 resp. 325 as well as via a coil 240 and a parallel circuit made up of a charging switch 220 and a charging diode 221, and alternatively or additionally connected to ground via the group selector switch 310 resp. 320 or via diode 315 resp. 325 as well as via the coil 240 and a parallel circuit made up of a discharging switch 230 or a discharging diode 231. Charging switch 220 and discharging switch 230 are implemented as transistors, for example, which are controlled via side drivers 222 resp. 232.

The voltage source comprises an element having capacitive properties which, in the example being considered, is the (buffer) capacitor 210. Capacitor 210 is charged by a battery 200 (for example a motor vehicle battery) and a DC voltage converter 201 downstream therefrom. DC voltage converter 201 converts the battery voltage (for example, 12 V) into substantially any other DC voltage (for example 250 V), and charges capacitor 210 to that voltage. DC voltage converter 201 is controlled by means of transistor switch 202 and resistor 203 which is utilized for current measurements taken from a measuring point 630.

For cross check purposes, a further current measurement at a measuring point 650 is allowed by activation IC E as well as by resistors 651, 652 and 653 and a 5 V DC voltage, for example, source 654; moreover, a voltage measurement at a measuring point 640 is allowed by activation IC E as well as by voltage dividing resistors 641 and 642.

Finally, a resistor 330 (referred to as total discharging resistor), a stop switch implemented as a transistor 331 (referred to as stop switch) , and a diode 332 (referred to as total discharging diode) serve to discharge the piezoelectric elements 10, 20, 30, 40, 50 and 60 (if they happen to be not discharged by the "normal" discharging operation as described further below). Stop switch 331 is preferably closed after "normal" discharging procedures (cycled discharging via discharge switch 230). It thereby connects piezoelectric elements 10, 20, 30, 40, 50 and 60 to ground through resistors 330 and 300, and thus removes any residual charges that might remain in piezoelectric elements 10, 20, 30, 40, 50 and 60. The total discharging diode 332 prevents negative voltages from occurring at the piezoelectric elements 10, 20, 30, 40, 50 and 60, which might in some circumstances be damaged thereby.

Charging and discharging of all the piezoelectric elements 10, 20, 30, 40, 50 and 60 or any particular one is accomplished by way of a single charging and discharging apparatus (common to all the groups and their piezoelectric elements). In the example being considered, the common charging and discharging apparatus comprises battery 200, DC voltage converter 201, capacitor 210, charging switch 220 and discharging switch 230, charging diode 221 and discharging diode 231 and coil 240.

The charging and discharging of each piezoelectric element works the same way and is explained in the following while referring to the first piezoelectric element 10 only.

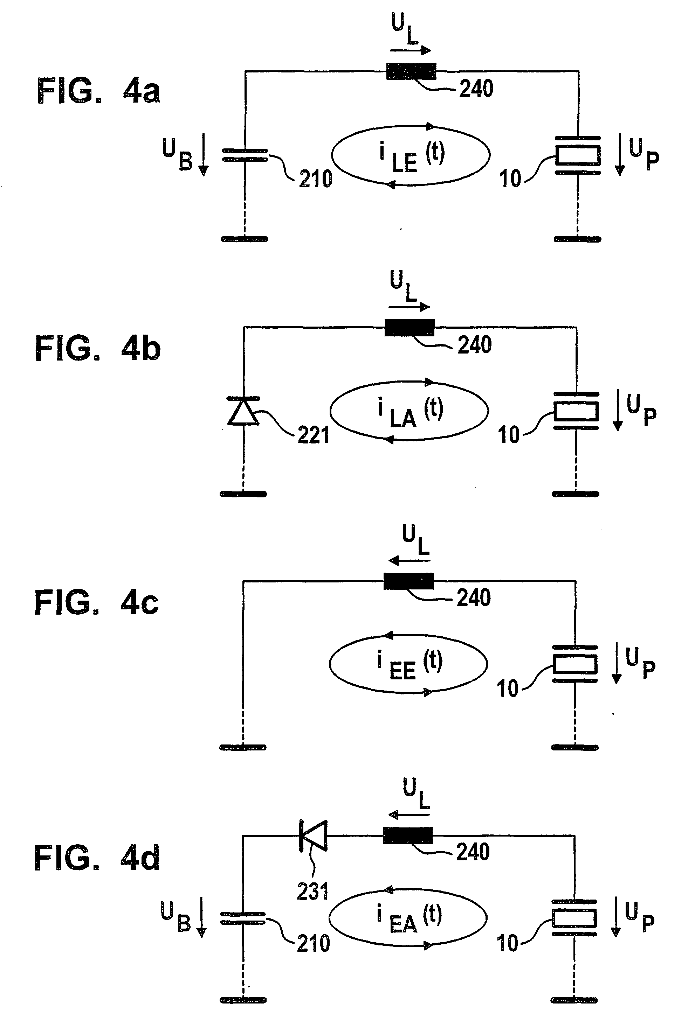

The conditions occurring during the charging and discharging procedures are explained with reference to Figs. 4a through 4d, of which Figs. 4a and 4b illustrate the charging of piezoelectric element 10, and Figs. 4c and 4d the discharging of piezoelectric element 10.

The selection of one or more particular piezoelectric elements 10, 20, 30, 40, 50 or 60 to be charged or discharged, the charging procedure as described in the following as well as the discharging procedure are driven by activation IC E and control unit D by means of opening or closing one or more of the above introduced switches 11, 21, 31, 41, 51, 61; 310, 320; 220, 230 and 331. The interactions between the elements within the detailed area A on the one hand and activation IC E and control unit D on the other hand are described in greater detail below.

Concerning the charging procedure, firstly any particular piezoelectric element 10, 20, 30, 40, 50 or 60 which is to be charged has to be selected. In order to exclusively charge the first piezoelectric element 10, the branch selector switch 11 of the first branch 110 is closed, whereas all other branch selector switches 21, 31, 41, 51 and 61 remain opened. In order to exclusively charge any other piezoelectric element 20, 30, 40, 50, 60 or in order to charge several ones at the same time they would be selected by closing the corresponding branch selector switches 21, 31, 41, 51 and/or 61.

Then, the charging procedure itself may take place:

Generally, within the example considered, the charging procedure requires a positive potential difference between capacitor 210 and the group selector piezo terminal 14 of the first piezoelectric element 10. However, as long as charging switch 220 and discharging switch 230 are open no charging or discharging of piezoelectric element 10 occurs: In this state, the circuit shown in Fig. 3 is in a steady-state condition, *i.e*., piezoelectric element 10 retains its charge state in substantially unchanged fashion, and no currents flow.

In order to charge the first piezoelectric element 10, charging switch 220 is closed. Theoretically, the first piezoelectric element 10 could become charged just by doing so. However, this would produce large currents which might damage the elements involved. Therefore, the occurring currents are measured at measuring point 620 and switch 220 is opened again as soon as the detected currents exceed a certain limit. Hence, in order to achieve any desired charge on the first piezoelectric element 10, charging switch 220 is repeatedly closed and opened whereas discharging switch 230 remains open.

In more detail, when charging switch 220 is closed, the conditions shown in Fig. 4a occur, *i*.*e*., a closed circuit comprising a series circuit made up of piezoelectric element 10, capacitor 210, and coil 240 is formed, in which a current i_{LE}(t) flows as indicated by arrows in Fig. 4a. As a result of this current flow both positive charges are brought to the group selector piezo terminal 14 of the first piezoelectric element 10 and energy is stored in coil 240.

When charging switch 220 opens shortly (for example, a few µs) after it has closed, the conditions shown in Fig. 4b occur: a closed circuit comprising a series circuit made up of piezoelectric element 10, charging diode 221, and coil 240 is formed, in which a current i_{LA}(t) flows as indicated by arrows in Fig. 4b. The result of this current flow is that energy stored in coil 240 flows into piezoelectric element 10. Corresponding to the energy delivery to the piezoelectric element 10, the voltage occurring in the latter, and its external dimensions, increase. Once energy transport has taken place from coil 240 to piezoelectric element 10, the steady-state condition of the circuit, as shown in Fig. 3 and already described, is once again attained.

At that time, or earlier, or later (depending on the desired time profile of the charging operation), charging switch 220 is once again closed and opened again, so that the processes described above are repeated. As a result of the re-closing and re-opening of charging switch 220, the energy stored in piezoelectric element 10 increases (the energy already stored in the piezoelectric element 10 and the newly delivered energy are added together), and the voltage occurring at the piezoelectric element 10, and its external dimensions, accordingly increase.

If the aforementioned closing and opening of charging switch 220 are repeated numerous times, the voltage occurring at the piezoelectric element 10, and the expansion of the piezoelectric element 10, rise in steps.

Once charging switch 220 has closed and opened a predefined number of times, and/or once piezoelectric element 10 has reached the desired charge state, charging of the piezoelectric element is terminated by leaving charging switch 220 open.

Concerning the discharging procedure, in the example considered, the piezoelectric elements 10, 20, 30, 40, 50 and 60 are discharged in groups (G1 and/or G2) as follows:

Firstly, the group selector switch(es) 310 and/or 320 of the group or groups G1 and/or G2 the piezoelectric elements of which are to be discharged are closed (the branch selector switches 11, 21, 31, 41, 51, 61 do not affect the selection of piezoelectric elements 10, 20, 30, 40, 50, 60 for the discharging procedure, since in this case they are bypassed by the branch diodes 12, 22, 32, 42, 52 and 62). Hence, in order to discharge piezoelectric element 10 as a part of the first group G1, the first group selector switch 310 is closed.

When discharging switch 230 is closed, the conditions shown in Fig. 4c occur: a closed circuit comprising a series circuit made up of piezoelectric element 10 and coil 240 is formed, in which a current i_{EE}(t) flows as indicated by arrows in Fig. 4c. The result of this current flow is that the energy (a portion thereof) stored in the piezoelectric element is transported into coil 240. Corresponding to the energy transfer from piezoelectric element 10 to coil 240, the voltage occurring at the piezoelectric element 10, and its external dimensions, decrease.

When discharging switch 230 opens shortly (for example, a few µs) after it has closed, the conditions shown in Fig. 4d occur: a closed circuit comprising a series circuit made up of piezoelectric element 10, capacitor 210, discharging diode 231, and coil 240 is formed, in which a current i_{EA}(t) flows as indicated by arrows in Fig. 4d. The result of this current flow is that energy stored in coil 240 is fed back into capacitor 210. Once energy transport has taken place from coil 240 to capacitor 210, the steady-state condition of the circuit, as shown in Fig. 3 and already described, is once again attained.

At that time, or earlier, or later (depending on the desired time profile of the discharging operation), discharging switch 230 is once again closed and opened again, so that the processes described above are repeated. As a result of the re-closing and re-opening of discharging switch 230, the energy stored in piezoelectric element 10 decreases further, and the voltage occurring at the piezoelectric element, and its external dimensions, also accordingly decrease.

If the aforementioned closing and opening of discharging switch 230 are repeated numerous times, the voltage occurring at the piezoelectric element 10, and the expansion of the piezoelectric element 10, decrease in steps.

Once discharging switch 230 has closed and opened a predefined number of times, and/or once the piezoelectric element has reached the desired discharge state, discharging of the piezoelectric element 10 is terminated by leaving discharging switch 230 open.

The interaction between the activation IC E and control unit D on the one hand and the elements within the detailed area A on the other hand is performed by control signals sent from activation integrated circuit (IC) E to elements within the detailed area A via branch selector control lines 410, 420, 430, 440, 450, 460, group selector control lines 510, 520, stop switch control line 530, charging switch control line 540 and discharging switch control line 550 and control line 560. On the other hand, there are sensor signals obtained on measuring points 600, 610, 620, 630, 640, 650 within the detailed area A which are transmitted to activation IC E via sensor lines 700, 710, 720, 730, 740, 750.

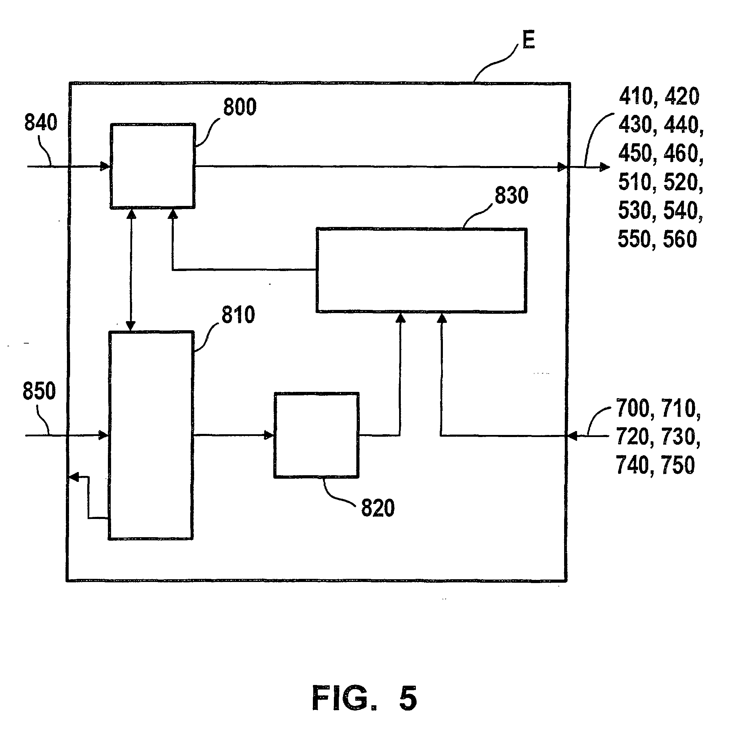

The control lines are used to apply or not to apply voltages to the transistor bases in order to select piezoelectric elements 10, 20, 30, 40, 50 or 60, to perform charging or discharging procedures of single or several piezoelectric elements 10, 20, 30, 40, 50, 60 by means of opening and closing the corresponding switches as described above. The sensor signals are particularly used to determine the resulting voltage of the piezoelectric elements 10, 20 and 30, resp. 40, 50 and 60 from measuring points 600 resp. 610 and the charging and discharging currents from measuring point 620. The control unit D and the activation IC E are used to combine both kinds of signals in order to perform an interaction of both as will be described in detail now while referring to Figs. 3 and 5.

As is indicated in Fig. 3, the control unit D and the activation IC E are connected to each other by means of a parallel bus 840 and additionally by means of a serial bus 850. The parallel bus 840 is particularly used for fast transmission of control signals from control unit D to the activation IC E, whereas the serial bus 850 is used for slower data transfer.

In Fig. 5 some components are indicated, which the activation IC E comprises: a logic circuit 800, RAM memory 810, digital to analog converter system 820 and comparator system 830. Furthermore, it is indicated that the fast parallel bus 840 (used for control signals) is connected to the logic circuit 800 of the activation IC E, whereas the slower serial bus 850 is connected to the RAM memory 810. The logic circuit 800 is connected to the RAM memory 810, to the comparator system 830 and to the signal lines 410, 420, 430, 440, 450 and 460; 510 and 520; 530; 540, 550 and 560. The RAM memory 810 is connected to the logic circuit 800 as well as to the digital to analog converter system 820. The digital to analog converter system 820 is further connected to the comparator system 830. The comparator system 830 is further connected to the sensor lines 700 and 710; 720; 730, 740 and 750 and -as already mentioned- to the logic circuit 800.

The above listed components may be used in a charging procedure for example as follows:

By means of the control unit D a particular piezoelectric element 10, 20, 30, 40, 50 or 60 is determined which is to be charged to a certain target voltage. Hence, firstly the value of the target voltage (expressed by a digital number) is transmitted to the RAM memory 810 via the slower serial bus 850. The target voltage can be, for example, the value for Uₒₚₜ used in a main injection, as described above with respect to Fig. 1. Later or simultaneously, a code corresponding to the particular piezoelectric element 10, 20, 30, 40, 50 or 60 which is to be selected and the address of the desired voltage within the RAM memory 810 is transmitted to the logic circuit 800 via the parallel bus 840. Later on, a strobe signal is sent to the logic circuit 800 via the parallel bus 840 which gives the start signal for the charging procedure.

The start signal firstly causes the logic circuit 800 to pick up the digital value of the target voltage from the RAM memory 810 and to put it on the digital to analog converter system 820 whereby at one analog exit of the converters 820 the desired voltage occurs. Moreover, said analog exit (not shown) is connected to the comparator system 830. In addition hereto, the logic circuit 800 selects either measuring point 600 (for any of the piezoelectric elements 10, 20 or 30 of the first group G1) or measuring point 610 (for any of the piezoelectric elements 40, 50 or 60 of the second group G2) to the comparator system 830. Resulting thereof, the target voltage and the present voltage at the selected piezoelectric element 10, 20, 30, 40, 50 or 60 are compared by the comparator system 830. The results of the comparison, i.e. the differences between the target voltage and the present voltage, are transmitted to the logic circuit 800. Thereby, the logic circuit 800 can stop the procedure as soon as the target voltage and the present voltage are equal to one another.

Secondly, the logic circuit 800 applies a control signal to the branch selector switch 11, 21, 31, 41, 51 or 61 which corresponds to any selected piezoelectric element 10, 20, 30, 40, 50 or 60 so that the switch becomes closed (all branch selector switches 11, 21, 31, 41, 51 and 61 are considered to be in an open state before the onset of the charging procedure within the example described). Then, the logic circuit 800 applies a control signal to the charging switch 220 so that the switch becomes closed. Furthermore, the logic circuit 800 starts (or continues) measuring any currents occurring on measuring point 620. Hereto, the measured currents are compared to any predefined maximum value by the comparator system 830. As soon as the predefined maximum value is achieved by the detected currents, the logic circuit 800 causes the charging switch 220 to open again.

Again, the remaining currents at measuring point 620 are detected and compared to any predefined minimum value. As soon as said predefined minimum value is achieved, the logic circuit 800 causes the charging switch 220 to close again and the procedure starts once again.

The closing and opening of the charging switch 220 is repeated as long as the detected voltage at measuring point 600 or 610 is below the target voltage. As soon as the target voltage is achieved, the logic circuit stops the continuation of the procedure.

The discharging procedure takes place in a corresponding way: Now the selection of the piezoelectric element 10, 20, 30, 40, 50 or 60 is obtained by means of the group selector switches 310 resp. 320, the discharging switch 230 instead of the charging switch 220 is opened and closed and a predefined minimum target voltage is to be achieved.

The timing of the charging and discharging operations and the holding of voltage levels in the piezoelectric elements 10, 20, 30, 40, 50 or 60, as for example, the time of a main injection, can be according to a valve stroke, as shown, for example, in Fig. 2.

It is to be understood that the above given description of the way charging or discharging procedures take place are exemplary only. Hence, any other procedure which utilizes the above described circuits or other circuits might match any desired purpose and any corresponding procedure may be used in place of the above described example.

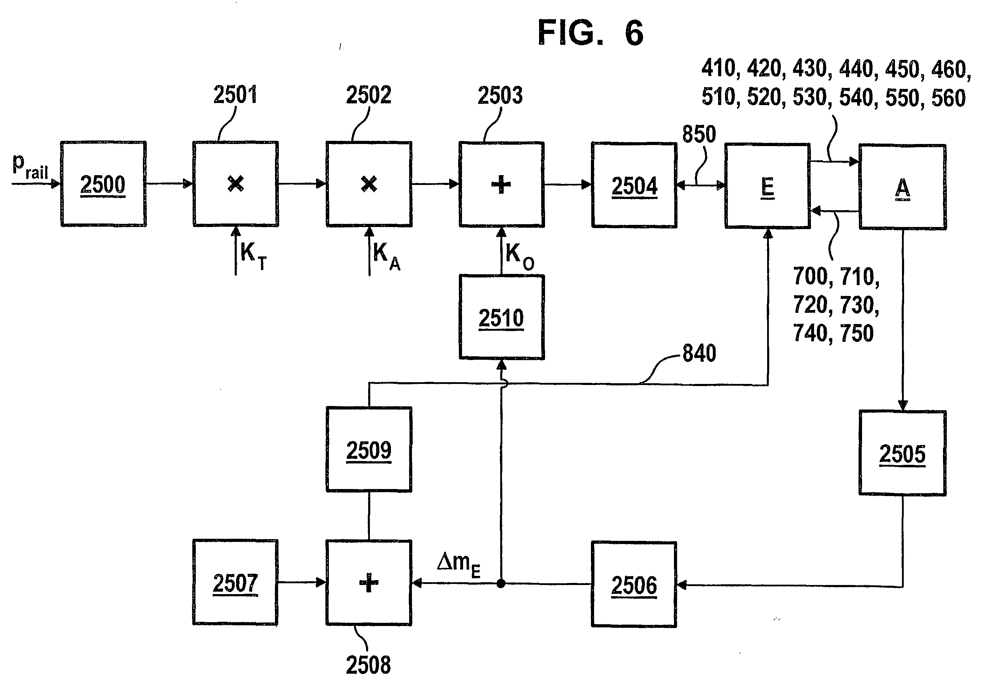

Fig. 6 shows a configuration for controlling a combustion engine 2505. This configuration comprises a basic voltage calculation unit 2500 which calculates a basic voltage to be applied to the piezoelectric elements 10, 20, 30, 40, 50, and 60, of the circuit included in the detailed area A of Fig. 6; the detailed area A is also shown in Fig. 4. The basic voltage calculation unit 2500 calculates a basic voltage dependent on the pressure pᵣₐᵢₗ in the pressurized fuel supply line of the fuel injection system. In a preferred embodiment, the basic voltage is corrected via a first correction block 2501 using a temperature correction value K_{T}. The output from the first correction block 2501 is a corrected basic voltage. This corrected basic voltage is preferably corrected by a second or subsequent correction block 2502 using an aging correction value K_{A}. The first and second correction blocks 2501 and 2502 are preferably multipliers, *i.e*., the basic voltage is multiplied by the temperature correction value K_{T} and the output enters the second or subsequent correction block 2502 and is multiplied by the aging correction value K_{A}. The aging correction value K_{A} is calculated via a correction value calculation unit 2512. The correction block 2502 and the correction value calculation unit 2512 are part of a compensation unit 2511. The output of the second or subsequent correction block 2502 is preferably further corrected via a third or subsequent correction block 2503 using an online correction value Kₒ. The third or subsequent correction block 2503 is preferably implemented as an adder, *i*.*e*., the online correction value Kₒ is preferably added to the output of the second or subsequent correction block 2502. The output of the third or subsequent correction block 2503 is preferably fed through a voltage and voltage gradient controller 2504.

The basic voltage calculation unit 2500 and the correction blocks 2501, 2502, and 2503, as well as the voltage and voltage gradient controller 2504 are software modules implemented in control unit D in Fig. 3.

Further, in Fig. 6, the voltage and voltage gradient controller 2504 is connected to the activation IC E shown in Fig. 3 via the serial bus 850. The activation IC E is connected to the circuit within the detailed area A via the signal lines 410, 420, 430, 440, 450, 460, 510, 520, 530, 540, 550, 560, 700, 710, 720, 730, 740, and 750. The fuel injection into the combustion engine 2505 is controlled via the piezoelectric elements 10, 20, 30, 40, 50, and 60, of the circuit within the detailed area A shown in Fig. 3. The rotational speed of the combustion engine 2505 is measured and fed into a fuel correction unit 2506. The fuel correction unit 2506 comprises a frequency analyzer which evaluates the frequency of the rotational speed. The fuel correction unit 2506 calculates a fuel correction value ΔQ_{E} upon this frequency analysis for each individual cylinder o the combustion engine 2505.

The configuration shown in Fig. 6 also comprises a fuel volume calculation unit 2507 calculating a desired fuel volume Q_{E}. The desired fuel volume is added to the fuel volume correction value ΔQ_{E} via an adder 2508. The sum of the desired fuel volume Q_{E} and the fuel volume correction value ΔQ_{E} is fed into a fuel metering unit 2509. The fuel metering unit calculates the time a voltage has to be applied to the piezoelectric elements 10, 20, 30, 40, 50 and 60, to inject fuel into the combustion engine 2505. The fuel correction unit 2506, the adder 2508, the fuel volume calculation unit 2507, and the fuel metering unit 2509 are implemented in the control unit D. Time signals to signaling when a voltage has to be applied to the piezoelectric elements 10, 20 ,30, 40, 50 and 60, to inject fuel into the combustion engine 2505 are transferred from the fuel metering unit 2509 to the activation IC E via the parallel bus 840.

The online correction value Kₒ is calculated by an online optimization unit 2510. The online optimization unit 2510 calculates the online correction value Kₒ based upon the fuel correction value ΔQ_{E} calculated by the fuel correction unit 2506.

The Uₒₚₜ values can change as a function of operating characteristics of the fuel injection system, such as, for example, fuel pressure, as fully described in co-pending application entitled "Method and Apparatus for Charging a Piezoelectric Element" (attorney docket number 10744/11, filed by the assignee of the present invention on even date herewith and incorporated herein by reference in its entirety) and, especially, sample to sample of the injection system, for example, the injector and the piezoelectric element, and its age.

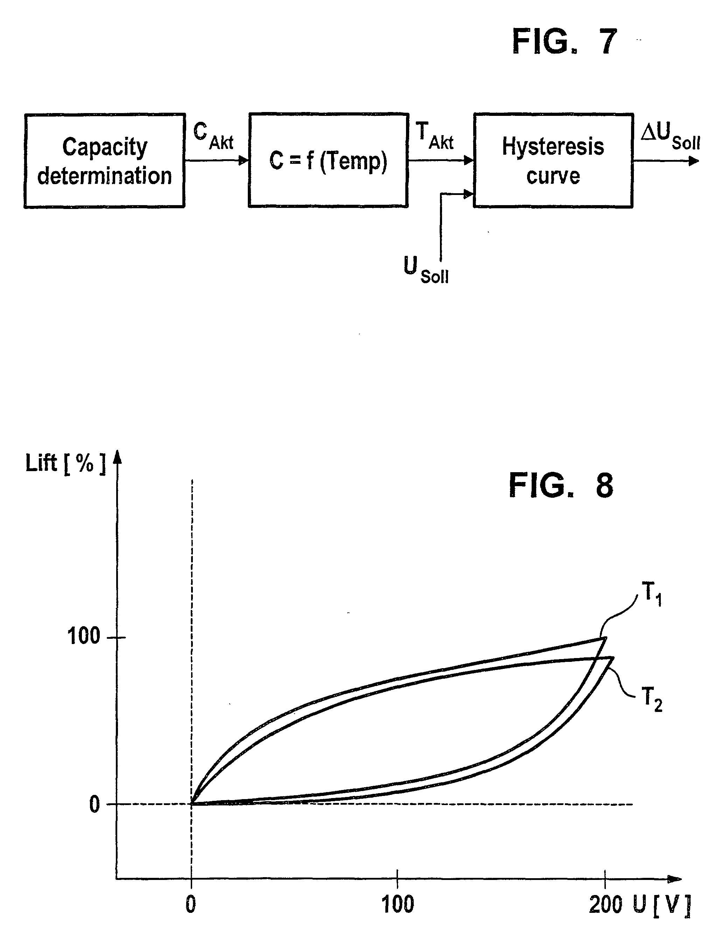

Fig. 7 shows a functional depiction of how to determine the voltage offset resulting from the temperature hysteresis dependency effect of the piezoelectric actuators discussed earlier. It begins with a capacitance determination, including the actual capacitance of a given piezoelectric element, which as discussed before is a function of temperature. The current capacitance C_{Akt}, the current temperature T_{Akt} and the desired voltage U_{Soll} are used to calculate the hysteresis curve for a given piezoelectric element. Based on the resulting characteristic curve, a desired voltage offset ΔUₛₒₗₗ can be determined, which then can be used to correct the piezoelectric's travel.

Fig. 8 shows a number of the actuator travel versus voltage hysteresis curves, that are calculated in Fig. 7. As can be seen in Fig. 8, at different piezoelectric element temperatures (T₁ and T₂) the curves shift with respect to travel at given voltages. These shifts cause imprecise expansion of the piezoelectric element, which correspond to inaccurate positioning of the nozzle needle. As Fig. 7 indicated, in order to compensate for this temperature dependence, a voltage offset is calculated, which is then added to or subtracted from the voltage applied to the piezoelectric element.

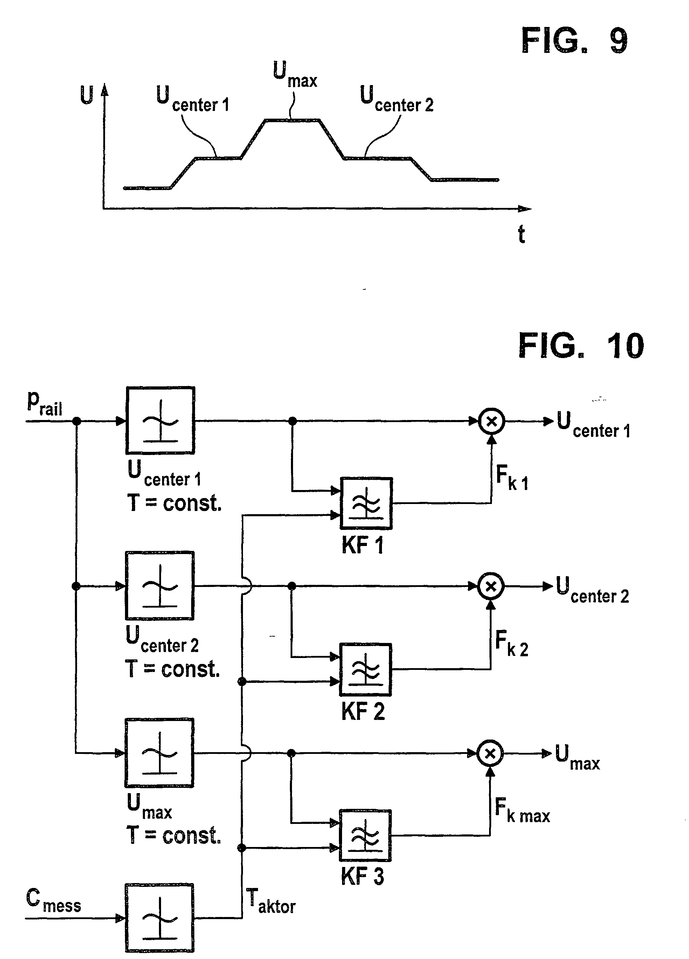

Fig. 9 shows a graph of the voltage applied to a piezoelectric element over the time of a single charge/discharge cycle. Starting from an applied voltage of 0, a first voltage, U_{center1} is applied to the piezoelectric element, the voltage then is ramped up to Uₘₐₓ for a set time, then ramped down to U_{center2}, and finally the applied voltage is removed. Due to the temperature dependence of the piezoelectric element, at each of the three identified voltage points, U_{center1}, Uₘₐₓ, and U_{center2}, a corresponding voltage offset must be calculated. This is in order to compensate for the temperature hysteresis effect and accurately position the nozzle needle.

Fig. 10 shows a schematic of the method used to determine the voltage offset for each of the identified applied voltage points. As was noted earlier, the piezoelectric element temperature can not be generally measured, therefore, the capacitance of the piezoelectric element is used instead.

To determine the voltage offsets the following method is used. Initially, baseline measurements are conducted and resulting hysteresis curves are recorded at defined actuator temperatures as shown in Fig. 8. These baseline curves, for example, can be performed on a test bench under reproducible conditions. From these actuator temperatures, the instantaneous capacitances of a given actuator can be determined.

Once the baseline curves have been determined, for a given line pressure pᵣₐᵢₗ, a desired activation voltage uₛₒₗₗ can be determined at a constant temperature. Thus, as shown in the diagram, an initial activation voltage can be estimated for each of the voltages U_{center1}, U_{center2}, and Uₘₐₓ at a given constant temperature. Thereafter, each of these estimated voltages can be corrected to take into account the actual temperature of the piezoelectric element. As mentioned previously, the temperature can advantageously be determined from a measured capacitance of the piezoelectric element Cₘₑₛₛ. A correction factor Fₖ₁, Fₖ₂, Fₖₘₐₓ can then be determined using the estimated initial activation voltage and the temperature of the piezoelectric element Tₐₖₜₒᵣ using a characteristic curve KF1, KF2, and KF3. The resulting correction factor Fₖ₁, Fₖ₂, Fₖₘₐₓ represents the change in linear expansion of the piezoelectric element with respect to a set of baseline or standard conditions. If the change in expansion of the piezoelectric element at its operating temperature is greater than that at the standard conditions, the quotient is less than one. Otherwise, the quotient is greater than one.

To determine the voltage offset necessary to correct for the temperature dependence of the piezoelectric element, each correction factor Fₖ₁, Fₖ₂, Fₖₘₐₓ is multiplied by the estimated initial activation voltages, U_{center1}, U_{center2}, and Uₘₐₓ. By doing this, the drive voltage is corrected for the temperature dependence of the piezoelectric element. For example, the drive voltage is reduced if the linear expansion for the given piezoelectric element is greater than that under standard conditions or increased if the linear expansion for the given piezoelectric element is less than that under standard conditions.

## Claims

1. Fuel injection system with a piezoelectric element (10, 20, 30, 40, 50 or 60) for controlling the amount of injected fuel by charging and/or discharging the piezoelectric element (10, 20, 30, 40, 50 or 60), wherein the fuel injection system comprises a control unit (D) for determining an activation voltage for charging the piezoelectric element (10, 20, 30, 40, 50 or 60) as a function of the temperature of the piezoelectric element (10, 20, 30, 40, 50 or 60), **characterized in that**
the control unit (D) comprises a temperature dependent hysteresis curve which relates the actuator travel of the piezoelectric element (10, 20, 30, 40, 50, 60) versus the voltage across the piezoelectric element (10, 20, 30, 40, 50 or 60) and which is used for determining the activation voltage.

2. The fuel injection system as defined in claim 1, **characterized in that** the control unit (D) determines the temperature of the piezoelectric element (10, 20, 30, 40, 50 or 60) by measuring the capacitance of the piezoelectric element (10, 20, 30, 40, 50 or 60).

3. The fuel injection system as defined in claims 1 or 2, **characterized in that** the activation voltage for charging the piezoelectric element (10, 20, 30, 40, 50 or 60) comprises a baseline characteristic voltage and a voltage offset.

4. The apparatus as defined in claim 3, **characterized in that** the voltage offset is a function of the temperature of the piezoelectric element (10, 20, 30, 40, 50 or 60).

5. Method for operating a fuel injection system with a piezoelectric element (10, 20, 30, 40, 50 or 60) for controlling an amount of injected fuel by charging and/or discharging the piezoelectric element (10, 20, 30, 40, 50 or 60), wherein an activation voltage is determined for charging the piezoelectric element (10, 20, 30, 40, 50 or 60), the activation voltage being a function of the temperature of the piezoelectric element (10, 20, 30, 40, 50 or 60), **characterized in that** a temperature dependent hysteresis curve is used for determining the activation voltage, wherein the hysteresis curve relates the actuator travel of the piezoelectric element (10, 20, 30, 40, 50 or 60) versus the voltage across the piezoelectric element (10, 20, 30, 40, 50 or 60).

6. The method as defined in claim 5, **characterized in that** the temperature of the piezoelectric element (10, 20, 30, 40, 50 or 60) is determined by measuring the capacitance of the piezoelectric element.

7. The method as defined in claims 5 or 6, **characterized in that** the activation voltage for charging the piezoelectric element (10, 20, 30, 40, 50 or 60) comprises a baseline characteristic voltage and a voltage offset.

8. The method as defined in claim 7, **characterized in that** the voltage offset is a function of the temperature of the piezoelectric element (10, 20, 30, 40, 50 or 60).

## Patentansprüche

1. Kraftstoffeinspritzsystem mit einem piezoelektrischen Element (10, 20, 30, 40, 50 oder 60) zum Steuern der eingespritzten Kraftstoffmenge durch Laden und/oder Entladen des piezoelektrischen Elements (10, 20, 30, 40, 50 oder 60), wobei das Kraftstoffeinspritzsystem eine Steuereinheit (D) umfaßt, um eine Aktivierungsspannung zum Laden des piezoelektrischen Elements (10, 20, 30, 40, 50 oder 60) als Funktion der Temperatur des piezoelektrischen Elements (10, 20, 30, 40, 50 oder 60) zu bestimmen, **dadurch gekennzeichnet, daß**
die Steuereinheit (D) eine temperaturabhängige Hysteresekurve umfaßt, die den Aktuatorweg des piezoelektrischen Elements (10, 20, 30, 40, 50 oder 60) zur Spannung am piezoelektrischen Element (10, 20, 30, 40, 50 oder 60) in Beziehung setzt und zum Bestimmen der Aktivierungsspannung verwendet wird.

2. Kraftstoffeinspritzsystem nach Anspruch 1, **dadurch gekennzeichnet, daß** die Steuereinheit (D) die Temperatur des piezoelektrischen Elements (10, 20, 30, 40, 50 oder 60) bestimmt, indem sie die Kapazität des piezoelektrischen Elements (10, 20, 30, 40, 50 oder 60) bestimmt.

3. Kraftstoffeinspritzsystem nach Anspruch 1 oder 2, **dadurch gekennzeichnet, daß** die Aktivierungsspannung zum Laden des piezoelektrischen Elements (10, 20, 30, 40, 50 oder 60) eine Basiskennspannung und einen Spannungsoffset umfaßt.

4. Vorrichtung nach Anspruch 3, **dadurch gekennzeichnet, daß** der Spannungsoffset eine Funktion der Temperatur des piezoelektrischen Elements (10, 20, 30, 40, 50 oder 60) ist.

5. Verfahren zum Betreiben eines Kraftstoffeinspritzsystems mit einem piezoelektrischen Element (10, 20, 30, 40, 50 oder 60) zum Steuern einer eingespritzten Kraftstoffmenge durch Laden und/oder Entladen des piezoelektrischen Elements (10, 20, 30, 40, 50 oder 60), wobei eine Aktivierungsspannung zum Laden des piezoelektrischen Elements (10, 20, 30, 40, 50 oder 60) bestimmt wird, wobei die Aktivierungsspannung eine Funktion der Temperatur des piezoelektrischen Elements (10, 20, 30, 40, 50 oder 60) ist, **dadurch gekennzeichnet, daß** eine temperaturabhängige Hysteresekurve verwendet wird, um die Aktivierungsspannung zu bestimmen, wobei die Hysteresekurve den Aktuatorweg des piezoelektrischen Elements (10, 20, 30, 40, 50 oder 60) zur Spannung am piezoelektrischen Element (10, 20, 30, 40, 50 oder 60) in Beziehung setzt.

6. Verfahren nach Anspruch 5, **dadurch gekennzeichnet, daß** die Temperatur des piezoelektrischen Elements (10, 20, 30, 40, 50 oder 60) bestimmt wird, indem die Kapazität des piezoelektrischen Elements bestimmt wird.

7. Verfahren nach Anspruch 5 oder 6, **dadurch gekennzeichnet, daß** die Aktivierungsspannung zum Laden des piezoelektrischen Elements (10, 20, 30, 40, 50 oder 60) eine Basiskennspannung und einen Spannungsoffset umfaßt.

8. Verfahren nach Anspruch 7, **dadurch gekennzeichnet, daß** der Spannungsoffset eine Funktion der Temperatur des piezoelektrischen Elements (10, 20, 30, 40, 50 oder 60) ist.

## Revendications

1. Système d'injection de carburant comprenant un élément piézoélectrique (10, 20, 30, 40, 50 ou 60) pour commander la quantité de carburant injecté en chargeant et/ou en déchargeant l'élément piézoélectrique (10, 20, 30, 40, 50 ou 60), dans lequel le système d'injection de carburant comprend une unité de commande (D) pour déterminer une tension d'activation pour charger l'élément piézoélectrique (10, 20, 30, 40, 50 ou 60) en fonction de la température de l'élément piézoélectrique (10, 20, 30, 40, 50 ou 60),
**caractérisé en ce que**
l'unité de commande (D) comprend une courbe d'hystérésis dépendant de la température qui montre la course d'actionnement de l'élément piézoélectrique (10, 20, 30, 40, 50 ou 60) en fonction de la tension à travers l'élément piézoélectrique (10, 20, 30, 40, 50 ou 60) et qui est utilisée pour déterminer la tension d'activation.

2. Système d'injection de carburant selon la revendication 1,
**caractérisé en ce que**
l'unité de commande (D) détermine la température de l'élément piézoélectrique (10, 20, 30, 40, 50 ou 60) en mesurant la capacitance de l'élément piézoélectrique (10, 20, 30, 40, 50 ou 60).

3. Système d'injection de carburant selon la revendication 1 ou 2,
**caractérisé en ce que**
la tension d'activation pour charger l'élément piézoélectrique (10, 20, 30, 40, 50 ou 60) comprend une tension caractéristique de base et un décalage de tension.

4. Système d'injection selon la revendication 3,
**caractérisé en ce que**
le décalage de tension dépend de la température de l'élément piézoélectrique (10, 20, 30, 40, 50 ou 60).

5. Procédé pour faire fonctionner un système d'injection de carburant comprenant un élément piézoélectrique (10, 20, 30, 40, 50 ou 60) pour commander une quantité de carburant injecté en chargeant et/ou en déchargeant l'élément piézoélectrique (10, 20, 30, 40, 50 ou 60), dans lequel une tension d'activation est déterminée pour charger l'élément piézoélectrique (10, 20, 30, 40, 50 ou 60), la tension d'activation étant une fonction de la température de l'élément piézoélectrique (10, 20, 30, 40, 50 ou 60),
**caractérisé en ce qu'**
une courbe d'hystérésis dépendant de la température est utilisée pour déterminer la tension d'activation, la courbe d'hystérésis étant relative à la course d'actionnement de l'élément piézoélectrique (10, 20, 30, 40, 50 ou 60) en fonction de la tension à travers l'élément piézoélectrique (10, 20, 30, 40, 50 ou 60).

6. Procédé selon la revendication 5,
**caractérisé en ce que**
la température de l'élément piézoélectrique (10, 20, 30, 40, 50 ou 60) est déterminée par la mesure de la capacitance de l'élément piézoélectrique.

7. Procédé selon la revendication 5 ou 6,
**caractérisé en ce que**
la tension d'activation pour charger l'élément piézoélectrique (10, 20, 30, 40, 50 ou 60) comprend une tension caractéristique de base et un décalage de tension.

8. Procédé selon la revendication 7,
**caractérisé en ce que**
le décalage de tension est une fonction de la température de l'élément piézoélectrique (10, 20, 30, 40, 50 ou 60).
